# EUROPÄISCHE PATENTANMELDUNG

(11) **EP 3 771 054 A1**
(43) Veröffentlichungstag der Anmeldung: **27.01.2021**
(21) Anmeldenummer: 19188335.4
(22) Anmeldetag: 25.07.2019
(51) Int. Cl.: H02H 3/087, H03K 17/082, H03K 17/687

(54) **ÜBERSTROMSCHUTZVORRICHTUNG FÜR EIN GLEICHSTROMNETZ**

(71) Anmelder: Siemens Aktiengesellschaft, 80333 München (DE)
(72) Erfinder: Andersch, Tobias, 92224 Amberg (DE); Langen, Stefan, 92280 Kastl (DE); Feil, Wolfgang, 92421 Schwandorf (DE); Kaluza, Peter, 92286 Rieden (DE)

(57) **Zusammenfassung**

Eine Überstromschutzvorrichtung in einem Lastpfad (2) eines Gleichstromnetzes umfasst eine steuerbare Halbleiter-Schaltanordnung (10) sowie eine Steuereinheit (20) mit einer Treiberschaltung (21) und mit einer Überstromüberwachungseinheit (22), die dazu ausgebildet ist, die Treiberschaltung (21) zum Sperrendschalten der steuerbaren Halbleiter-Schaltanordnung (10) zu veranlassen, wenn ein an einem Überstromüberwachungseingang (22S) anliegendes Spannungssignal (s₃) einen vorgegebenen Spannungsgrenzwert überschreitet. Eine in dem Lastpfad (2) angeordnete Strommesseinrichtung (30) erfasst die Höhe des durch die steuerbare Halbleiter-Schaltanordnung (10) fließenden Stroms und stellt ein die Stromgröße repräsentierendes Stromgrößensignal (s₁) bereit. Eine Auswerteschaltung (40) erzeugt aus dem ihr zugeführten Stromgrößensignal (s₁) ein Stromgrößen-Spannungssignal (s₂), das der Überstromüberwachungseinheit (22) an ihrem Überstromüberwachungseingang (22S) als das Spannungssignal (s₃) zugeführt wird. Das Stromgrößen-Spannungssignal (s₂) wird derart erzeugt, dass dieses einen Wert größerals den vorgegebenen Spannungsgrenzwert aufweist, wenn die Höhe des durch die steuerbare Halbleiter-Schaltanordnung (10) fließenden Stroms einen vordefinierten Stromgrenzwert, bei dem ein Sperrendschalten der steuerbaren Halbleiter-Schaltanordnung (10) durch die Steuereinheit (20) veranlasst werden soll, überschreitet.

## Beschreibung

Die Erfindung betrifft eine Überstromschutzvorrichtung für ein Gleichstromnetz. Insbesondere betrifft die Erfindung eine Überstromschutzvorrichtung für den Schutz von in einem Gleichstromnetz angeordneten Verbrauchern. Ferner betrifft die Erfindung ein Gleichstromnetz. Ferner betrifft die Erfindung ein Verfahren zum Schutz vor einem Überstrom in einem Lastpfad eines Gleichstromnetzes.

Lastanordnungen, die aus einem Gleichstromnetz (DC-Netz) versorgt werden, kommen insbesondere im industriellen Umfeld zum Einsatz. Die Versorgung von Lastanordnungen aus Gleichstromnetzen bietet den Vorteil, durch intelligente Netzsteuerung und integrierte Speicher flexibel und robust auf schwankende Netzqualität und Energieangebote reagieren zu können. Insbesondere können regenerative Energieerzeuger wie z.B. Batteriespeicher und/oder Photovoltaikanlagen leicht in ein Gleichstromnetz eingebunden werden. Wandlungsverluste von Wechsel- in Gleichspannung können dabei vermieden werden. Durch die Möglichkeit, Bremsenergie, z.B. von generatorisch betriebenen Antrieben, puffern zu können, ergeben sich Energieeinsparungen.

In derartigen Gleichstromnetzen ist es erforderlich, den in einem Lastpfad fließenden Strom überwachen zu können. Ferner soll die Möglichkeit bestehen, beim Auftreten eines zu hohen Stromes über eine in dem Lastpfad angeordnete Schaltanordnung den Strom in dem Lastpfad abschalten zu können. Diese Art der Überwachung ist insbesondere für Überlastfälle und Kurzschlussströme erforderlich.

Es ist bekannt, als Schaltelemente z.B. mechanische Leitungsschutzschalter oder Leistungsschaltelemente, welche Gleichströme schalten können, zu benutzen.

Ferner sind Schutzvorrichtungen bekannt, die ausschließlich mittels Halbleiter-Schaltelementen Gleichströme schalten. Die Halbleiter benötigen eine Ansteuerung, die eine schnelle Umladung der Kapazitäten des Schalters ermöglicht, wodurch die Ansteuerung eine hohe Komplexität aufweist.

Ferner sind Schutzvorrichtungen in Hybridtechnologie bekannt, die mittels Halbleiter-Schaltelementen eine Stromflussunterbrechung realisieren, wobei die Stromführung jedoch über mechanische Kontakte realisiert wird. Die Halbleiter-Schaltelemente solcher hybriden Überstromschutzvorrichtungen müssen dabei auf das Verhalten der mechanischen Schaltelemente abgestimmt sein und brauchen daher eine aufwändige Steuerung zum Abschalten eines Überstroms oder Kurzschlussstroms. Weiter benötigen mechanische Schaltelemente mehr Zeit, um solche Ströme abzuschalten

Grundsätzlich besteht bei allen genannten Varianten von Überstromschutzvorrichtungen jedoch das Problem, dass die Erkennung von Überströmen erst bei sehr hohen Überströmen möglich ist, so dass die Zeitdauer bis zur Aktivierung der Überstromschutzvorrichtung durch ein Sperrendschalten der darin verwendeten Schaltelemente verhältnismäßig lang ist. Auch wenn dies nicht unmittelbar zu einer Zerstörung von Komponenten der Überstromschutzvorrichtung führen muss, resultiert dies in einer hohen Belastung der Komponenten der Überstromschutzvorrichtung.

Es ist Aufgabe der Erfindung, eine Überstromschutzvorrichtung für ein Gleichstromnetz anzugeben, das baulich und/oder funktional verbessert ist und insbesondere eine schnellere und frühere Erkennung eines Überstroms ermöglicht. Es ist außerdem Aufgabe der Erfindung, ein Verfahren zum Schutz vor einem Überstrom in einem Lastpfad eines Gleichstromnetzes anzugeben.

Diese Aufgabe wird gelöst durch eine Überstromschutzvorrichtung für ein Gleichstromnetz gemäß den Merkmalen des Anspruches 1 sowie ein Gleichstromnetz, das eine erfindungsgemäß ausgebildete Überstromschutzvorrichtung umfasst.

Vorteilhafte Ausgestaltungen sind in den abhängigen Ansprüchen angegeben. Dabei können die in den abhängigen Vorrichtungsansprüchen angebenen weiteren Merkmale in analoger Weise auf das erfindungsgemäße Verfahren übertragen werden.

Es wird eine Überstromschutzvorrichtung für ein Gleichstromnetz vorgeschlagen. Die Überstromschutzvorrichtung dient z.B. für den Schutz eines in dem Gleichstromnetz angeordneten Verbrauchers. Bei einem solchen Verbraucher kann es sich insbesondere um einen oder mehrere kapazitive und/oder induktive Verbraucher handeln. Kapazitive Verbraucher sind beispielsweise Wechselrichter, welche aus der vom Gleichstromnetz bereitgestellten Spannung eine Dreh- oder wenigstens eine Wechselspannung für eine Last, z.B. einen Motor, erzeugen.

Die Überstromschutzvorrichtung umfasst eine steuerbare Halbleiter-Schaltanordnung, die in einem Lastpfad des Gleichstromnetzes angeordnet ist. Der Lastpfad verbindet beispielsweise ein Versorgungspotential, das an einer Versorgungsklemme oder -schiene anliegt, mit dem erwähnten Verbraucher.

Die Überstromschutzvorrichtung umfasst weiter eine Steuereinheit mit einer Treiberschaltung zur Ansteuerung der steuerbaren Halbleiter-Schaltanordnung und mit einer Überstromüberwachungseinheit, die dazu ausgebildet ist, die Treiberschaltung zum Sperrendschalten der steuerbaren Halbleiter-Schaltanordnung zu veranlassen, wenn ein an einem Überstromüberwachungseingang anliegendes Spannungssignal einen vorgegebenen Spannungsgrenzwert überschreitet.

Die Ansteuerung der steuerbaren Halbleiterschaltanordnung durch die Treiberschaltung umfasst ein Leitend- bzw. Sperrendschalten jeweiliger Halbleiter-Schaltelemente der Halbleiter-Schaltanordnung. Als Halbleiter-Schaltelemente werden insbesondere leistungselektronische Bauelemente wie z.B. MOSFETs (Metal Oxid Silicon Field Effect Transistor), IGBTs (Insulated Gate Bipolar Transistor) und dergleichen eingesetzt. Derartige leistungselektronische Bauelemente können vom n- oder p-Kanal-Typ bzw. npn- oder pnp-Typ sein. Das Halbleitermaterial kann auf Silizium (Si) oder SiC (Siliziumcarbid) oder Ähnlichem basieren. Umfasst die Halbleiter-Schaltanordnung mehr als ein steuerbares Halbleiter-Schaltelement, so sind in dem Lastpfad zwei der steuerbaren Halbleiter-Schaltelemente zweckmäßigerweise antiseriell miteinander verschaltet.

Als Überstromüberwachungseingang wird insbesondere ein sog. Entsättigungsüberwachungs-Anschluss der Steuereinheit genutzt. Dieser ist auch als sog. DESAT-Eingang bekannt, der je nach Ausgestaltung der Überstromüberwachungseinheit bei einem vorgegebenen Spannungsgrenzwert das Sperrendschalten der steuerbaren Halbleiter-Schaltanordnung veranlasst. Ein typischer vorgegebener Spannungsgrenzwert beträgt z.B. 9 V (bei 1200 V-Bauelementen) oder größer.

Ferner umfasst die Überstromschutzvorrichtung eine in dem Lastpfad angeordnete Strommesseinrichtung, die die Höhe des durch die steuerbare Halbleiter-Schaltanordnung fließenden Stroms erfasst und ein die Stromgröße repräsentierendes Stromgrößensignal bereitstellt. Gemäß zweckmäßigen Ausgestaltungen kann die Strommesseinrichtung dazu ausgebildet sein, als Stromgrößensignal eine Spannung oder einen Strom auszugeben. Im ersten Fall kann die Strommesseinrichtung z.B. im Lastpfad einen Shunt umfassen. Ist die Strommesseinrichtung dazu ausgebildet, als das Stromgrößensignal einen Strom auszugeben, so kann die Strommesseinrichtung z.B. einen Hall-Sensor, einen GMR-Sensor (GMR: Giant Magneto Resistance, d.h. einen ein Magnetfeld auswertenden Sensor), einen Sigma-Delta-Wandler oder einen AMR-Sensor (AMR: Anistrop Magneto Resistiv; Anbieter z.B. Firma Sensitec GmbH, DE) umfassen.

Schließlich umfasst die Überstromschutzvorrichtung eine Auswerteschaltung, die dazu ausgebildet ist, aus dem ihr zugeführten Stromgrößensignal ein zum Strom proportionales Stromgrößen-Spannungssignal zu erzeugen, das der Überstromüberwachungseinheit an ihrem Überstromüberwachungseingang als das Spannungssignal zugeführt wird. Ferner ist die Auswerteschaltung dazu ausgebildet, das Stromgrößen-Spannungssignal derart zu erzeugen, dass dieses einen Wert größer als den vorgegebenen Spannungsgrenzwert aufweist, wenn die Höhe des durch die steuerbare Halbleiter-Schaltanordnung fließenden Stroms einen vordefinierten Stromgrenzwert, bei dem ein Sperrendschalten der steuerbaren Halbleiter-Schaltanordnung durch die Steuereinheit veranlasst werden soll, überschreitet.

Die Auswerteschaltung "übersetzt" damit einen den Stromgrenzwert übersteigenden Wert des Stromgrößensignals in ein Stromgrößen-Spannungssignal, das entsprechend der Ausbildung der Überstromüberwachungseinheit einen Spannungspegel erreicht, der ausreichend ist, den vorgegebenen Spannungsgrenzwert zu überschreiten und dadurch das Sperrendschalten der steuerbaren Halbleiter-Schaltanordnung zu veranlassen.

Durch die vorgeschlagene Überstromschutzvorrichtung ist es, im Gegensatz zu den bekannten Lösungen, möglich, die Überstromschutzvorrichtung bereits bei wesentlich geringeren Überschreitungen des Nennstroms auszulösen. Unter einer Auslösung wird hierbei ein Sperrendschalten der steuerbaren Halbleiter-Schaltanordnung auf Veranlassung der Überstromüberwachungseinheit verstanden.

Die Auswerteschaltung dient damit in vorteilhafter Weise zur Aufbereitung des Stromgrößensignals, so dass dieses der Überstromüberwachungseinheit an ihrem Überstromüberwachungseingang zugeführt werden kann. Wenn der vorgegebene Stromgrenzwert überschritten ist, erzeugt die Auswerteschaltung das Stromgrößen-Spannungssignal derart, dass dieses einem Wert größer als dem vorgegebenen Spannungsgrenzwert entspricht, was zu einem Auslösen der Überstromschutzvorrichtung führt.

Die vorgeschlagene Überstromschutzvorrichtung nutzt damit eine in vielen Steuereinheiten vorhandene Entsättigungsüberwachungs-Signalstrecke, die dafür vorgesehen ist, die Halbleiter-Schaltanordnung bei großen Überströmen, die z.B. das 4-bis 6-fache des Nennstromes betragen, abzuschalten. Die Kombination aus Strommesseinrichtung und Auswerteschaltung ermöglicht es, die Halbleiter-Schaltanordnung bereits bei kleineren Überströmen in den sperrenden Zustand zu bringen.

Ermöglicht wird dies dadurch, dass die Strommesseinrichtung und die Auswerteschaltung dazu ausgebildet sind, ein entsättigtes Halbleiter-Schaltelement der Halbleiter-Schaltanordnung zu emulieren.

Der Stromgrenzwert, bei dem das die Auslösung erzeugende Stromgrößen-Spannungssignal erzeugt wird, ist zweckmäßigerweise variabel einstellbar. Der Stromgrenzwert I_{g} ist dabei variabel einstellbar zwischen den Grenzen Iₙₑₙₙ < I_{g} < x * Iₙₑₙₙ. Mit anderen Worten kann der Stromgrenzwert zwischen dem Nennstrom Iₙₑₙₙ und dem x-fachen (z.B. x = 5) des Nennstroms (als äußerste Grenze) gewählt werden.

In einer zweckmäßigen Ausgestaltung kann die Auswerteschaltung einen Mikrocontroller umfassen, auf dem ein Programm zur Auswertung des Stromgrößensignals und zur Erzeugung des Stromgrößen-Spannungssignals ausgeführt wird. Mit anderen Worten kann die Auswerteschaltung in Software realisiert werden, welche durch den Mikrocontroller ausgeführt wird.

Die Auswerteschaltung kann zusätzlich oder alternativ als Transistorstufe ausgebildet sein, die das Stromgrößen-Spannungssignal erzeugt. In der einfachsten Ausgestaltung kann die Auswerteschaltung als Verstärker ausgebildet sein, welcher aus der Stromgrößeninformation das Stromgrößen-Spannungssignal erzeugt.

Gemäß einer weiteren zweckmäßigen Ausgestaltung kann die Auswerteschaltung dazu ausgebildet sein, die Ausgabe des Stromgrößen-Spannungssignals in Abhängigkeit des Stromgrößensignals zu verzögern. Beispielsweise kann bei einer geringen Überschreitung des Nennstroms (z.B. dem 2-fachen Nennstrom) das Stromgrößen-Spannungssignal nach einer Zeitspanne t₁ seit dem Erfassen des Überstroms erzeugt werden, wohingegen bei einer größeren Überschreitung des Nennstroms (z.B. der 4-fachen Überschreitung des Nennstroms) eine Erzeugung das Stromgrößen-Spannungssignal nach einer Zeitspanne t₂ seit dem Auftreten des Überstroms erfolgt, wobei t₂ kleiner als t₁ ist. Abhängig von der Ausgestaltung der Auswerteschaltung kann hierbei eine beliebige Abstufung für unterschiedliche Stromgrößensignale erfolgen, welche z.B. in einer Tabelle hinterlegt sind oder durch eine Gleichung beschrieben sind.

In einer einfacheren Ausgestaltung kann die Halbleiter-Schaltanordnung lediglich ein einziges steuerbares Halbleiter-Schaltelement umfassen. Wie bereits beschrieben, kann die Halbleiter-Schaltanordnung auch mehrere steuerbare Halbleiter-Schaltelemente umfassen, wobei insbesondere eine Ausgestaltung mit zwei antiseriell miteinander verschalteten Halbleiter-Schaltelementen vorgesehen ist.

Gemäß einem weiteren Aspekt wird ein Gleichstromnetz mit einer wie hierin beschriebenen Überstromschutzvorrichtung vorgeschlagen. Das Gleichstromnetz weist die gleichen Vorteile auf, wie diese vorstehend in Verbindung mit der erfindungsgemäßen Überstromschutzvorrichtung beschrieben wurden.

Gemäß einem weiteren Aspekt wird ein Verfahren zum Schutz vor einem Überstrom in einem Lastpfad eines Gleichstromnetzes vorgeschlagen. Das Verfahren umfasst folgende Schritte: Erfassen der Höhe eines durch eine in dem Lastpfad angeordnete steuerbare Halbleiter-Schaltanordnung fließenden Stroms; dieser Erfassungschritt erfolgt vorzugsweise durch eine in dem Lastpfad angeordnete Strommesseinrichtung. Bereitstellen eines die Stromgröße repräsentierendes Stromgrößensignals. Erzeugen eines Stromgrößen-Spannungssignals aus dem Stromgrößensignal derart, dass dieses einen Wert größer als einen vorgegebenen Spannungsgrenzwert aufweist, wenn die Höhe des durch die steuerbare Halbleiter-Schaltanordnung fließenden Stroms einen vordefinierten Stromgrenzwert, bei dem ein Sperrendschalten der steuerbaren Halbleiter-Schaltanordnung veranlasst werden soll, überschreitet; dieser Erzeugungsschritt erfolgt vorzugsweise durch eine Auswerteschaltung. Zuführen des Stromgrößen-Spannungssignals einem Überstromüberwachungseingang einer Überstromüberwachungseinheit einer zur Ansteuerung der steuerbaren Halbleiter-Schaltanordnung vorgesehenen Steuereinheit als Spannungssignal. Und Veranlassen, vorzugsweise einer Treiberschaltung der Steuereinheit, die steuerbare Halbleiter-Schaltanordnung sperrend zu schalten, wenn das an dem Überstromüberwachungseingang anliegende Spannungssignal den vorgegebenen Spannungsgrenzwert überschreitet; dieser Veranlassungsschritt erfolgt vorzugsweise durch die Überstrom-überwachungseinheit der Steuereinheit.

Die skizzierte Aufgabenstellung wird auch durch ein erfindungsgemäßes Computerprogrammprodukt gelöst. Das Computerprogrammprodukt ist in einer Steuereinheit ausführbar ausgebildet. Das Computerprogrammprodukt kann als Software oder Firmware in einem Speicher speicherbar und durch ein Rechenwerk ausführbar ausgebildet sein. Alternativ oder ergänzend kann das Computerprogrammprodukt auch zumindest teilweise als festverdrahtete Schaltung ausgebildet sein, beispielsweise als ASIC. Das Computerprogrammprodukt ist dazu ausgebildet, ein Spannungssignal zu empfangen, auszuwerten und Befehle an eine Treiberschaltung der Steuereinheit zu erzeugen. Erfindungsgemäß ist das Computerprogrammprodukt dazu ausgebildet, mindestens eine Ausführungsform des skizzierten Verfahrens zum Schutz vor einem Überstrom in einem Lastpfad eines Gleichstromnetzes umzusetzen und durchzuführen. Dabei kann das Computerprogrammprodukt sämtliche Teilfunktionen des Verfahrens in sich vereinigen, also monolithisch ausgebildet sein. Alternativ kann das Computerprogrammprodukt auch segmentiert ausgebildet sein und jeweils Teilfunktionen auf Segmente verteilen, die auf separater Hardware ausgeführt werden. Beispielsweise kann ein Teil des Verfahrens in der Auswerteschaltung durchgeführt werden und ein anderer Teil des Verfahrens in der Steuereinheit, wie beispielsweise einer SPS oder einer Computer-Cloud.

Die Erfindung wird nachfolgend näher anhand von Ausführungsbeispielen in der Zeichnung beschrieben. Es zeigen:
- Fig. 1: eine schematische Darstellung einer ersten, allgemeinen Ausgestaltungsvariante einer erfindungsgemäßen Überstromschutzvorrichtung;
- Fig. 2: eine schematische Darstellung einer zweiten Ausgestaltungsvariante einer erfindungsgemäßen Überstromschutzvorrichtung;
- Fig. 3: eine schematische Darstellung einer dritten Ausgestaltungsvariante einer erfindungsgemäßen Überstromschutzvorrichtung; und
- Fig. 4: eine schematische Darstellung einer vierten Ausgestaltungsvariante einer erfindungsgemäßen Überstromschutzvorrichtung.

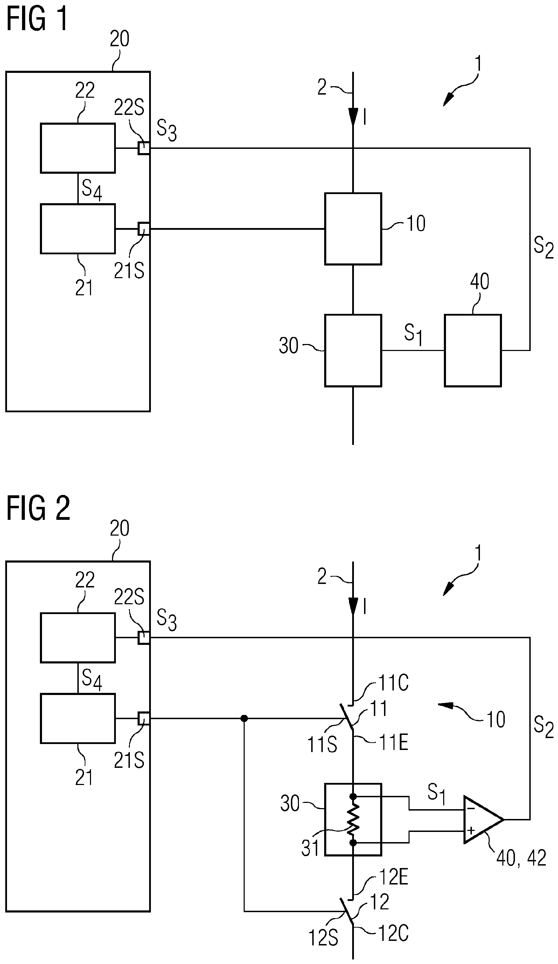

Die Figuren 1 bis 4 zeigen schematische Darstellungen einer Überstromschutzvorrichtung 1 für den Schutz eines in einem Gleichstromnetz angeordneten und in den Figuren jeweils nicht dargestellten Verbrauchers. Das im Detail ebenfalls nicht dargestellte Gleichstromnetz (DC-Netz) stellt an einer Versorgungsklemme oder -schiene eine Gleichspannung bereit. Die Gleichspannung kann beispielsweise von einer Batterie bereitgestellt werden. Es kann sich auch um eine andere beliebige Energiequelle oder eine Kombination mehrerer Energiequellen handeln, an deren Klemmen eine Gleichspannung bereitgestellt wird. Solche Energiequellen können z.B. eine Photovoltaikanlage und/oder ein Batteriespeicher sein, aber auch ein Gleichrichter, der die Gleichspannung durch Gleichrichtung einer von einer Wechselspannungsquelle erzeugten Wechselspannung erzeugt.

Da weder die Ausgestaltung des Gleichspannungsnetzes noch der Verbraucher im Detail für das Verständnis der Erfindung von Bedeutung ist, ist in den Figuren 1 bis 4 lediglich ein Lastpfad 2 dargestellt, der die Versorgungsklemme oder -schiene und den oder die Verbraucher über die Überstromschutzvorrichtung 1 verbindet.

Die Überstromschutzvorrichtung 1 umfasst eine im Lastpfad 2 angeordnete Halbleiter-Schaltanordnung 10. Die steuerbare Halbleiter-Schaltanordnung 10 umfasst zumindest ein steuerbares Halbleiter-Schaltelement 11, 12 (wie in den Figuren 2 bis 4 gezeigt). Als steuerbare Halbleiter-Schaltelemente 11, 12 kommen insbesondere leistungselektronische Bauelemente, wie z.B. MOSFETs oder IGBTs, in Betracht. Das oder die leistungselektronischen Bauelemente können vom n- oder p-Kanal-Typ bzw. vom npn- oder pnp-Typ sein. Das Halbleitermaterial kann auf Silizium (Si) oder Galliumnitrid (GaN) oder ähnlichem basieren.

Eine Ansteuerung des oder der steuerbaren Halbleiter-Schaltelemente 11, 12 der Halbleiter-Schaltanordnung 10 erfolgt durch eine Steuereinheit 20. Die Steuereinheit 20 umfasst eine Treiberschaltung 21, welche an einem Signalausgang 21S ein Ansteuersignal für die Halbleiter-Schaltanordnung 10 bereitstellt, mit dem ein jeweiliges steuerbares Halbleiter-Schaltelement 11, 12 leitend- oder sperrend geschaltet werden kann. In den Figuren 1 bis 4 werden die steuerbaren Halbleiter-Schaltelemente 11, 12 durch ein gemeinsames Ansteuersignal der Treiberschaltung 21 angesteuert. Dem Fachmann ist klar, dass jedes der steuerbaren Halbleiter-Schaltelemente 11, 12 auch durch unterschiedliche Ansteuersignale angesteuert werden könnte, die von unterschiedlichen Treiberschaltungen erzeugt werden.

Die Steuereinheit 20 umfasst ferner eine Überstromüberwachungseinheit 22. Die Überstromüberwachungseinheit 22 ist mit einem Überstromüberwachungseingang 22S der Steuereinheit 20 gekoppelt. An diesem empfängt die Überstromüberwachungseinheit 22 ein Spannungssignal s₃, wobei dann, wenn das Spannungssignal einen vorgegebenen Spannungsgrenzwert überschreitet, ein Steuersignal s₄ für die Treiberschaltung 21 erzeugt wird, um die Schaltelemente der Halbleiter-Schaltanordnung 10 sperrend zu schalten.

Der Überstromüberwachungseingang 22S ist ein bei typischen Steuereinheiten 20 vorhandener Entsättigungsüberwachungs-Pin (DESAT-Pin), der mittels der üblicherweise ebenfalls vorhandenen Überstromüberwachungseinheit 22 bei großen Überströmen I in dem Lastpfad 2 das Steuersignal s₄ erzeugt. Große Überströme sind typischerweise das 4- bis 6-fache des durch den Lastpfad 2 fließenden Nennstroms Iₙₑₙₙ, die sich prinzipbedingt ergeben.

Bei herkömmlichen Überstromschutzvorrichtungen repräsentiert das Spannungssignal sₛ eine über einem der Halbleiter-Schaltelemente der Halbleiter-Schaltanordnung 10 abfallende Spannung. Damit die über der Laststrecke des Halbleiter-Schaltelements abfallende Spannung den vorgegebenen Spannungsgrenzwert erreicht bzw. überschreitet, muss der durch die Halbleiter-Schaltanordnung 10 fließende Strom I mindestens das 4-fache des Nennstroms Iₙₑₙₙ aufweisen.

Um diesen prinzipbedingten Nachteil zu umgehen, sieht die erfindungsgemäße Überstromschutzvorrichtung 1 in dem Lastpfad 2 eine Strommesseinrichtung 30 vor. Mit anderen Worten ist die Strommesseinrichtung 30 in Serie zu der Halbleiter-Schaltanordnung 10 angeordnet. Die Strommesseinrichtung 30 erfasst die Höhe des durch die Halbleiter-Schaltanordnung 10 fließenden Stromes I und stellt ein die Stromgröße repräsentierendes Stromgrößensignal s₁ bereit. Das Stromgrößensignal s₁ repräsentiert in Abhängigkeit der Ausgestaltung der Strommesseinrichtung 30 entweder einen Spannungs- oder einen Stromwert.

Das Stromgrößensignal s₁ wird einer Auswerteschaltung 40 zugeführt. Die Auswerteschaltung 40 ist dazu ausgebildet, aus dem ihr zugeführten Stromgrößensignal s₁ ein Stromgrößen-Spannungssignal s₂ zu erzeugen, welches der Überstromüberwachungseinheit 22 an ihrem Überstromüberwachungseingang 22S als das Spannungssignal s₃ zugeführt wird, d.h. s₂ = s₃. Die Auswerteschaltung 40 erzeugt das Stromgrößen-Spannungssignal s₂ dabei derart, dass dieses einen Wert größer als den vorgegebenen Spannungsgrenzwert (der Überstromüberwachungseinheit 22) aufweist, wenn die Höhe des durch die steuerbare Halbleiter-Schaltanordnung 10 fließenden Stroms I einen vordefinierten Stromgrenzwert, der variabel einstellbar ist, überschreitet. Der vordefinierte Stromgrenzwert wird derart gewählt, dass bei dessen Überschreiten ein Sperrendschalten der steuerbaren Halbleiter-Schaltanordnung 10 durch die Steuereinheit 20 veranlasst wird, indem die Überstromüberwachungseinheit 22 das Überschreiten des vorgegebenen Spannungsgrenzwerts feststellt und das Steuersignal s₄ für die Treiberschaltung 21 ausgibt, wodurch die Treiberschaltung die Halbleiter-Schaltanordnung 10 sperrend schaltet.

Das grundlegende Prinzip der Überstromschutzvorrichtung 1 sieht somit vor, das durch die Strommesseinrichtung 30 erzeugte Stromgrößensignal s₁ durch die Auswerteschaltung 40 derart aufzubereiten, dass an dem Überstromüberwachungseingang 22S ein (DC-)Signal anliegt, das zum Sperrendschalten der Halbleiter-Schaltanordnung 10 führt. Die Strommesseinrichtung 30 und die Auswerteschaltung 40 emulieren somit ein entsättigtes Halbleiter-Schaltelement der Halbleiter-Schaltanordnung und können dadurch als das Spannungssignal s₃ eine Spannung erzeugen, die aktiv wird, wenn die Bedingung für eine Überlast und/oder einen Kurzschluss erfüllt ist.

Dadurch ist es möglich, die Halbleiter-Schaltanordnung 10 auch schon bei kleineren Überströmen, z.B. dem 1,2-, 1,5- oder 2-fachen des Nenn-Stromes in den sperrenden Zustand zu bringen.

Dadurch, dass die Signalführung galvanisch nicht getrennt sein muss, ergibt sich eine schnelle Reaktionsgeschwindigkeit und ein kostengünstiger Aufbau der Überstromschutzvorrichtung.

Die Figuren 2 bis 4 zeigen nachfolgend verschiedene Ausführungsformen des vorstehend beschriebenen Verfahrens.

In Fig. 2 umfasst die Halbleiter-Schaltanordnung 10 ein erstes und ein zweites Halbleiter-Schaltelement 11 und 12, die antiseriell miteinander verschaltet sind. Das erste und das zweite Halbleiter-Schaltelement 11, 12 sind beispielsweise IGBTs. Entsprechende Freilauf-Dioden sind der Übersichtlichkeit halber nicht dargestellt. Steueranschlüsse 11S, 12S des ersten und zweiten Halbleiter-Schaltelements 11, 12 empfangen ein gemeinsames Ansteuersignal vom Signalausgang 21S der Treiberschaltung 21 der Steuereinheit 20. Die Strommesseinrichtung 30, hier in Gestalt eines Shunts 31, ist seriell zwischen dem ersten und dem zweiten Halbleiter-Schaltelement 11, 12 angeordnet. Dabei sind jeweilige Emitteranschlüsse 11E, 12E des ersten und zweiten Halbleiter-Schaltelements 11, 12 mit jeweiligen Anschlüssen des Shunts 31 verbunden. Kollektoranschlüsse 11C, 12C sind in dem Lastpfad auf der vom Shunt 31 abgewandten Seite angeordnet.

Beispielhaft ist die Auswerteschaltung 40 als Operationsverstärker ausgebildet. Bauartbedingt stellt die Strommesseinrichtung 30 in Gestalt des Shunts 31 als Stromgrößensignal s₁ eine Spannung bereit, die an den Eingängen des Verstärkers 42 erfasst wird. Der Verstärker 42 erzeugt dann das Stromgrößen-Spannungssignal s₂, das als das Spannungssignal s₃ der Überstromüberwachungseinheit 22 zugeführt wird.

Obwohl die Strommesseinrichtung 30 in Gestalt des Shunts 31 im vorliegenden Ausführungsbeispiel zwischen dem ersten und dem zweiten Halbleiter-Schaltelement 11, 12 vorgesehen ist, ist dies nicht zwingend erforderlich. Es ist lediglich von Bedeutung, dass die Strommesseinrichtung 30 in Serie zu den Elementen der Halbleiter-Schaltanordnung in dem Lastpfad 2 angeordnet ist.

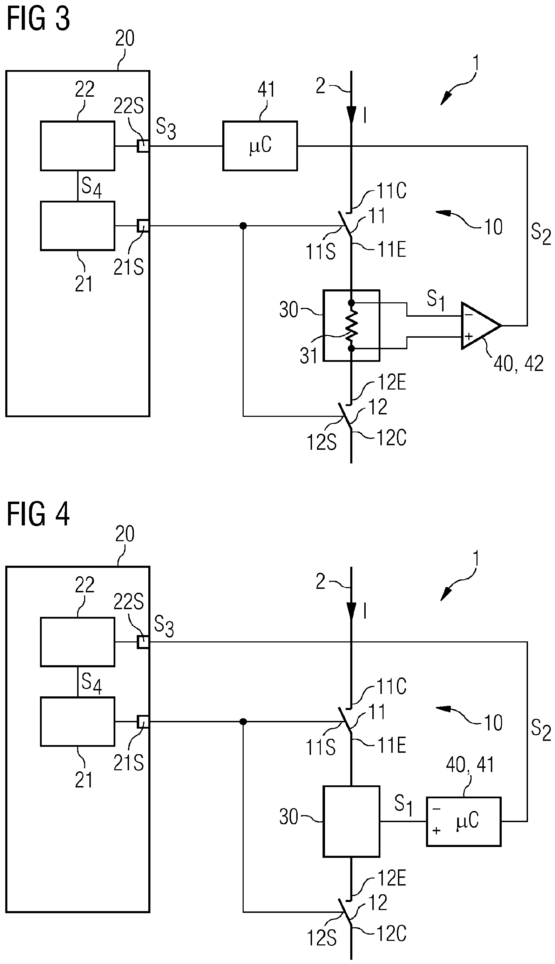

Fig. 3 zeigt eine Abwandlung des in Fig. 2 beschriebenen Ausführungsbeispiels, bei der das Stromgrößen-Spannungssignal s₂ einem Mikrocontroller 41 zugeführt wird, welcher dann das Spannungssignal s₃ erzeugt und am Überstromüberwachungseingang 22S bereitstellt. Mit Hilfe des Mikrocontrollers 41 ist es beispielsweise möglich, das Stromgrößen-Spannungssignal s₂, z.B. durch eine Filterung, aufzubereiten und weitere Anpassungen, z.B. im Hinblick auf eine Signallaufzeit, vorzunehmen. Beispielsweise kann eine Verzögerung des Spannungssignals s₃ in Abhängigkeit der Höhe des Überstroms in dem Lastpfad 2 vorgesehen werden.

Fig. 4 zeigt ein weiteres Ausführungsbeispiel, in dem als Strommesseinrichtung 30 beispielsweise ein Hall-Sensor, ein GMR-Sensor oder ein Sigma-Delta-Wandler verwendet wird, wobei dann als Stromgrößensignal s₁ ein Strom ausgegeben wird. Die Verwendung von Hall-Sensoren oder GMR-Sensoren als Strommesseinrichtung weist den Vorteil auf, dass eine galvanische Trennung zur Messstelle erfolgt. In dem in Fig. 4 gezeigten Ausführungsbeispiel ist die Funktion der Auswerteschaltung 40 durch eine auf einem Mikrocontroller 41 ablaufende Software realisiert. Der Mikrocontroller 41 stellt an seinem Ausgang das Stromgrößen-Spannungssignal s₂ als das Spannungssignal s₃ bereit (d.h. s₂ = s₃).

Die Auswerteschaltung 40 nimmt die Signalaufbereitung des Stromgrößensignals s₁ vor, das nach der Auslösebedingung den Überstromüberwachungseingang 22S mit dem entsprechenden Stromgrößen-Spannungssignal s₃ triggert, um damit das Sperrendschalten des oder der Schaltelemente der Halbleiter-Schaltanordnung 10 einzuleiten.

## Patentansprüche

1. Überstromschutzvorrichtung für ein Gleichstromnetz, umfassend:
- eine steuerbare Halbleiter-Schaltanordnung (10), die in einem Lastpfad (2) des Gleichstromnetzes angeordnet ist;
- eine Steuereinheit (20) mit einer Treiberschaltung (21) zur Ansteuerung der steuerbaren Halbleiter-Schaltanordnung (10) und mit einer Überstromüberwachungseinheit (22), die dazu ausgebildet ist, die Treiberschaltung (21) zum Sperrendschalten der steuerbaren Halbleiter-Schaltanordnung (10) zu veranlassen, wenn ein an einem Überstromüberwachungseingang (22S) anliegendes Spannungssignal (s₃) einen vorgegebenen Spannungsgrenzwert überschreitet;
- eine in dem Lastpfad (2) angeordnete Strommesseinrichtung (30), die die Höhe des durch die steuerbare Halbleiter-Schaltanordnung (10) fließenden Stroms erfasst und ein die Stromgröße repräsentierendes Stromgrößensignal (s₁) bereitstellt;
- eine Auswerteschaltung (40), die dazu ausgebildet ist, aus dem ihr zugeführten Stromgrößensignal (s₁) ein Stromgrößen-Spannungssignal (s₂) zu erzeugen, das der Überstromüberwachungseinheit (22) an ihrem Überstromüberwachungseingang (22S) als das Spannungssignal (s₃) zugeführt wird, und
wobei die Auswerteschaltung (40) ferner dazu ausgebildet ist, das Stromgrößen-Spannungssignal (s₂) derart zu erzeugen, dass dieses einen Wert größer als den vorgegebenen Spannungsgrenzwert aufweist, wenn die Höhe des durch die steuerbare Halbleiter-Schaltanordnung (10) fließenden Stroms einen vordefinierten Stromgrenzwert, bei dem ein Sperrendschalten der steuerbaren Halbleiter-Schaltanordnung (10) durch die Steuereinheit (20) veranlasst werden soll, überschreitet.

2. Überstromschutzvorrichtung nach Anspruch 1, **dadurch gekennzeichnet, dass** die Strommesseinrichtung (30) dazu ausgebildet ist, als das Stromgrößensignal (s₁) eine Spannung auszugeben.

3. Überstromschutzvorrichtung nach Anspruch 1, **dadurch gekennzeichnet, dass** die Strommesseinrichtung (30) dazu ausgebildet ist, als das Stromgrößensignal (s₁) einen Strom auszugeben.

4. Überstromschutzvorrichtung nach einem der vorhergehenden Ansprüche, **dadurch gekennzeichnet, dass** die Strommesseinrichtung (30) und die Auswerteschaltung (40) zusammen dazu ausgebildet sind, ein entsättigtes Halbleiter-Schaltelement der Halbleiter-Schaltanordnung (10) zu emulieren.

5. Überstromschutzvorrichtung nach einem der vorhergehenden Ansprüche, **dadurch gekennzeichnet, dass** der Stromgrenzwert variabel einstellbar ist.

6. Überstromschutzvorrichtung nach einem der vorhergehenden Ansprüche, **dadurch gekennzeichnet, dass** der Stromgrenzwert I_{g} gemäß Iₙₑₙₙ < I_{g} < x * Iₙₑₙₙ gewählt wird, wobei Iₙₑₙₙ ein durch den Lastpfad (2) fließender Nennstrom ist und 1 < x < 8 gilt.

7. Überstromschutzvorrichtung nach einem der vorhergehenden Ansprüche, **dadurch gekennzeichnet, dass** die Auswerteschaltung (40) einen Mikrocontroller (41) umfasst, auf dem ein Programm zur Auswertung des Stromgrößensignals (s₁) und zur Erzeugung des Stromgrößen-Spannungssignals (s₂) ausgeführt wird.

8. Überstromschutzvorrichtung nach einem der vorhergehenden Ansprüche, **dadurch gekennzeichnet, dass** die Auswerteschaltung (40) als Operationsverstärker (42) ausgebildet ist, der das Stromgrößen-Spannungssignals (s₂) erzeugt.

9. Überstromschutzvorrichtung nach einem der vorhergehenden Ansprüche, **dadurch gekennzeichnet, dass** die Auswerteschaltung (40) dazu ausgebildet ist, die Ausgabe des Stromgrößen-Spannungssignals (s₂) in Abhängigkeit des Stromgrößensignals (s₁) zu verzögern, ggf. einstellbar zu verzögern.

10. Überstromschutzvorrichtung nach einem der vorhergehenden Ansprüche, **dadurch gekennzeichnet, dass** die Halbleiter-Schaltanordnung (10) ein einziges steuerbares Halbleiter-Schaltelement (11 oder 12) oder zwei antiseriell miteinander verschaltete steuerbare Halbleiter-Schaltelemente (11, 12) umfasst.

11. Gleichstromnetz, umfassend eine Überstromschutzvorrichtung (1) gemäß einem der vorhergehenden Ansprüche.

12. Verfahren zum Schutze vor einem Überstrom in einem Lastpfad (2) eines Gleichstromnetzes, umfassend folgende Schritte:
Erfassen der Höhe eines durch eine in dem Lastpfad (2) angeordnete steuerbare Halbleiter-Schaltanordnung (10) fließenden Stroms;
Bereitstellen eines die Stromgröße repräsentierendes Stromgrößensignals (s₁);
Erzeugen eines Stromgrößen-Spannungssignals (s₂) aus dem Stromgrößensignal (s₁) derart, dass dieses einen Wert größer als einen vorgegebenen Spannungsgrenzwert aufweist, wenn die Höhe des durch die steuerbare Halbleiter-Schaltanordnung (10) fließenden Stroms einen vordefinierten Stromgrenzwert, bei dem ein Sperrendschalten der steuerbaren Halbleiter-Schaltanordnung (10) veranlasst werden soll, überschreitet;
Zuführen des Stromgrößen-Spannungssignals (s₂) einem Überstromüberwachungseingang (22S) einer Überstromüberwachungseinheit (22) einer zur Ansteuerung der steuerbaren Halbleiter-Schaltanordnung (10) vorgesehenen Steuereinheit (20) als Spannungssignal (s₃); und
Veranlassen, durch die Überstromüberwachungseinheit (22) der Steuereinheit (20), einer Treiberschaltung (21) der Steuereinheit (20), die steuerbare Halbleiter-Schaltanordnung (10) sperrend zu schalten, wenn das an dem Überstromüberwachungseingang (22S) anliegende Spannungssignal (s₃) den vorgegebenen Spannungsgrenzwert überschreitet.

13. Computerprogrammprodukt, das in einer Steuereinheit (20) ausführbar ist, **dadurch gekennzeichnet, dass** das Computerprogrammprodukt zur Durchführung eines Verfahrens nach Anspruch 12 ausgebildet ist.
